# EUROPEAN PATENT SPECIFICATION

(11) **EP 3 832 699 B1**
(45) Date of publication and mention of the grant of the patent: **05.03.2025**
(21) Application number: 19861586.6
(22) Date of filing: 02.08.2019
(51) Int. Cl.: H01L 21/336, H01L 21/3205, H01L 21/768, H01L 21/8234, H01L 23/522, H01L 27/088, H01L 29/78, H01L 29/06, H01L 29/20, H01L 29/417, H01L 29/423, H01L 23/48, H01L 23/482

(54) **SEMICONDUCTOR ELEMENT AND ELECTRONIC CIRCUIT**
HALBLEITERELEMENT UND ELEKTRONISCHE SCHALTUNG
ÉLÉMENT SEMI-CONDUCTEUR ET CIRCUIT ÉLECTRONIQUE

(30) Priority: 21.09.2018 JP 2018177640
(43) Date of publication of application: 09.06.2021
(73) Proprietor: Sony Semiconductor Solutions Corporation, Atsugi-shi, Kanagawa 243-0014 (JP)
(72) Inventor: SATO, Masahiro, Atsugi-shi, Kanagawa 243-0014 (JP); KAWAMURA, Takashi, Atsugi-shi, Kanagawa 243-0014 (JP)
(74) Representative: D Young & Co LLP
(86) International application number: PCT/JP2019/030459
(87) International publication number: WO 2020/059322

(56) References cited:
- JP-A- 2003 007 844
- JP-A- 2011 524 079
- JP-A- H06 310 955
- JP-A- H1 174 505
- JP-A- H11 251 445
- US-B1- 6 436 773

## Description

### TECHNICAL FIELD

The present disclosure relates to a semiconductor device and an electronic circuit. More specifically, the present disclosure relates to a semiconductor device including MOS transistors and an electronic circuit using the semiconductor device.

### BACKGROUND ART

As a MOS transistor used in a high-frequency analog signal amplifier circuit, a MOS transistor including an octagonal ring-shaped gate electrode, a drain region inside the gate electrode, and an octagonal source region outside the gate electrode has been proposed (see, for example, Patent Document 1). In this MOS transistor, the resistance of a gate wire is reduced by forming the gate electrode in an octagonal shape and connecting a gate lead wire to each of two opposing sides of the gate electrode. Further, the resistance of a source wire is reduced by a plurality of contacts being placed on the source region and connected in parallel. Furthermore, a drain wire is connected to the drain region via a contact placed on the drain region. By reducing the resistance of the gate wire and the source wire, the minimum noise figure of the MOS transistor according to the conventional technique is effectively reduced.

### CITATION LIST

### PATENT DOCUMENT

Patent Document 1: Japanese Patent Application Laid-Open No. H10-214971

US 6436773 B1 discloses a test field effect transistor. In US 6436773 B1, for fabricating a test field effect transistor on a semiconductor substrate, a layer of gate dielectric material is deposited on the semiconductor substrate, and a layer of gate electrode material is deposited on the layer of gate dielectric material. A dummy structure is formed on the gate electrode material, and the dummy structure is disposed over a shaped area of the gate electrode material and of the semiconductor substrate. The dummy structure has at least one sidewall around a perimeter of the shaped area. A spacer structure is formed to surround the at least one sidewall of the dummy structure outside of the perimeter of the shaped area. The dummy structure is etched away such that the shaped area of the gate electrode material is exposed and such that the spacer structure remains outside of the perimeter of the shaped area. Any exposed regions of the gate electrode material and of the gate dielectric material not under the spacer structure are etched away. The gate dielectric material remaining under the spacer structure forms a gate dielectric of the test field effect transistor, and the gate electrode material remaining under the spacer structure forms a gate electrode of the test field effect transistor. A drain and source dopant is implanted into exposed regions of the semiconductor substrate to form a first drain or source junction within the shaped area surrounded by the gate dielectric and the gate electrode, and to form a second drain or source junction outside the shaped area beyond the gate dielectric and the gate electrode. A width of the test field effect transistor is the perimeter of the shaped area, and a length of the test field effect transistor is the width of the gate dielectric and the gate electrode extending out from the perimeter of the shaped area.

### SUMMARY OF THE INVENTION

### PROBLEMS TO BE SOLVED BY THE INVENTION

In the above-mentioned conventional technique, since the drain region has a shape surrounded by the ring-shaped gate electrode, multi-layer wiring via contacts is required to connect a wire from the drain. Therefore, there is a problem that wiring length becomes long. If gate wiring and drain wiring become long, a circuit that amplifies a millimeter-wave-band signal has a problem of increased losses.

The present disclosure has been made in view of the above-mentioned problems. It is an object of the present disclosure to shorten the wiring length of MOS transistors.

### SOLUTIONS TO PROBLEMS

The invention is defined by the claims.

By adopting such aspects, the lengths of signal lines formed by the gate wire and the drain wire made smaller in width than the central part of the source region are expected to be shortened.

### BRIEF DESCRIPTION OF DRAWINGS

Fig. 1 is a circuit diagram showing a configuration example of an amplifier circuit according to a first embodiment of the present disclosure.
Fig. 2 is a diagram showing a configuration example <<Continue to Page 7>> of the amplifier circuit according to the first embodiment of the present disclosure.
Fig. 3 is a diagram showing a configuration example of a conventional amplifier circuit.
Fig. 4 is a diagram showing a configuration example of a semiconductor device according to the first embodiment of the present disclosure.
Fig. 5 is a diagram showing a configuration example of a semiconductor device according to a first modification of the first embodiment of the present disclosure.
Fig. 6 is a diagram showing a configuration example of a semiconductor device according to a second modification of the first embodiment of the present disclosure.
Fig. 7 is a diagram showing a configuration example of a semiconductor device according to a third modification of the first embodiment of the present disclosure.
Fig. 8 is a diagram showing a configuration example of a semiconductor device according to a fourth modification of the first embodiment of the present disclosure.
Fig. 9 is a diagram showing a configuration example of an amplifier circuit according to a second embodiment of the present disclosure, not within the wording of the claims
Fig. 10 is a diagram showing a configuration example of a semiconductor device according to a modification of the second embodiment of the present disclosure, not within the wording of the claims.
Fig. 11 is a circuit diagram showing a configuration example of an amplifier circuit according to a third embodiment of the present disclosure.
Fig. 12 is a diagram showing a configuration example of semiconductor devices according to the third embodiment of the present disclosure.
Fig. 13 is a diagram showing a configuration example of the amplifier circuit according to the third embodiment of the present disclosure.
Fig. 14 is a diagram showing a configuration example of a conventional amplifier circuit.
Fig. 15 is a diagram showing a configuration example of an amplifier circuit according to a fourth embodiment of the present disclosure.
Fig. 16 is a circuit diagram showing a configuration example of an amplifier circuit according to a fifth embodiment of the present disclosure.
Fig. 17 is a diagram showing a configuration example of the amplifier circuit according to the fifth embodiment of the present disclosure.
Fig. 18 is a diagram showing a configuration example of a semiconductor device according to a sixth embodiment of the present disclosure.

### MODE FOR CARRYING OUT THE INVENTION

Next, modes for carrying out the present disclosure (hereinafter, referred to as embodiments) will be described with reference to the drawings. In the drawings described below, the same or similar reference numerals are assigned to the same or similar parts. However, the drawings are schematic, and the dimensional ratios of individual parts and the like do not always agree with actual ones. Further, it is needless to say that the drawings include portions where each other's dimensional relationships and ratios are different between them. Furthermore, the embodiments will be described in the following order.
1. First embodiment
2. Second embodiment
3. Third embodiment
4. Fourth embodiment
5. Fifth embodiment
6. Sixth embodiment

### <1. First embodiment>

### [Circuit configuration]

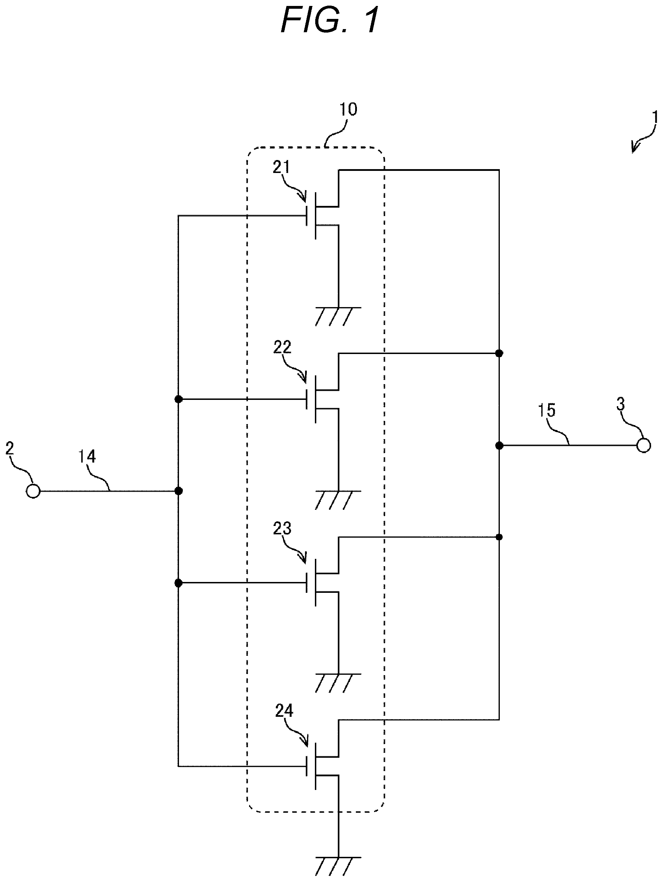

Fig. 1 is a circuit diagram showing a configuration example of an amplifier circuit according to a first embodiment of the present disclosure. The amplifier circuit 1 in the figure includes an input terminal 2, an output terminal 3, and MOS transistors 21 to 24.

The amplifier circuit 1 in the figure is a circuit that amplifies a signal input to the input terminal 2 and outputs it to the output terminal 3. The gates of the MOS transistors 21, 22, 23, and 24 are connected to the input terminal 2 together via an input signal line 14. The sources of the MOS transistors 21, 22, 23, and 24 are connected to a grounding conductor. The drains of the MOS transistors 21, 22, 23, and 24 are connected to the output terminal 3 together via an output signal line 15. In this way, the MOS transistors 21 to 24 are connected in parallel to amplify a signal input to their respective gates. Note that the power of the MOS transistors 21, 22, 23, and 24 is supplied via the output terminal 3. As will be described later, the MOS transistors 21, 22, 23, and 24 are formed on a semiconductor substrate as a single semiconductor device (semiconductor device 10). Note that the amplifier circuit 1 is an example of an electronic circuit described in the claims.

### [Configuration of semiconductor device]

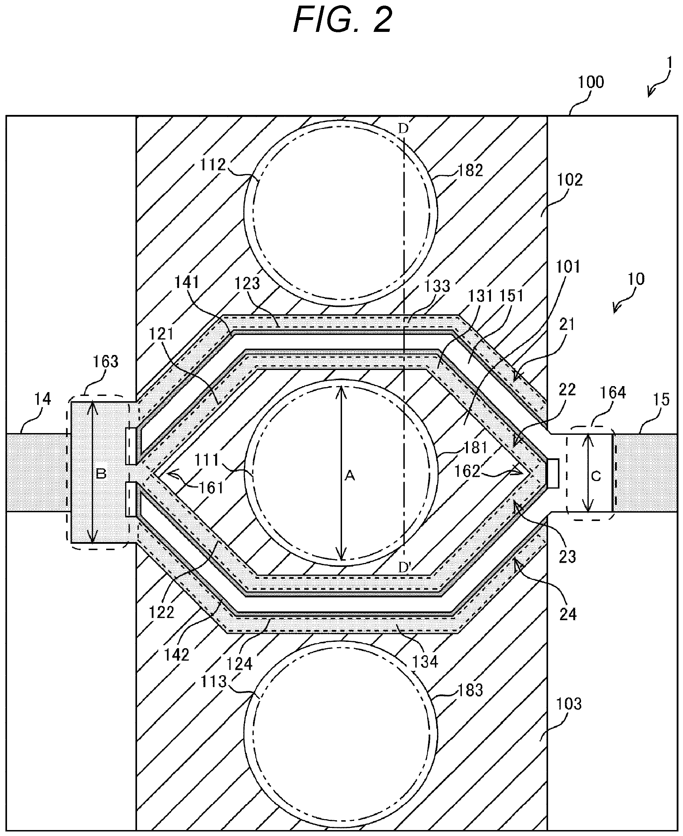

Fig. 2 is a diagram showing a configuration example of the amplifier circuit according to the first embodiment of the present disclosure. The figure is a plan view showing a configuration example of the amplifier circuit 1. The amplifier circuit 1 is formed on a semiconductor substrate 100. The amplifier circuit 1 in the figure includes the semiconductor device 10, the input signal line 14, and the output signal line 15.

Further, the semiconductor device 10 in the figure includes source regions 101 to 103, channel regions 121 to 124, drain regions 141 and 142, gate electrodes 131, 133, and 134, a gate wire 163, a drain electrode 151, and a drain wire 164. The semiconductor device 10 in the figure further includes source electrodes 181 to 183 and via plugs 111 to 113. In the figure, broken lines indicate the channel regions 121 to 124, dotted lines indicate the gate wire 163 and the drain wire 164, and dash-dot-dot lines indicate the via plugs 111 to 113.

The source region 101 constitutes a common source of the MOS transistors 22 and 23 described in Fig. 1. The source region 101 is formed in a horizontally elongated hexagonal shape, and has two ends (ends 161 and 162) made smaller in width than its central part. The source region 101 in the figure represents an example having the ends 161 and 162 formed in a tapered shape. Furthermore, the ends 161 and 162 in the figure each represent an example formed in a tapered shape with an angle of 90 degrees. The source electrode 181 is placed adjacent to the surface of the source region 101. Further, the via plug 111 is formed in the source region 101. The via plug 111 extends through the semiconductor substrate 100 to connect the source electrode 181 and a source wire 109 (not shown) described later.

The channel region 121 constitutes the channel of the MOS transistor 22. Further, the channel region 122 constitutes the channel of the MOS transistor 23. The channel regions 121 and 122 are placed adjacent to the source region 101, and are placed around the corresponding outer peripheral parts of the source region 101 divided by the ends 161 and 162. In the semiconductor device 10 in the figure, the channel regions 121 and 122 are placed above and below the source region 101 placed in the center of the figure, respectively. Note that the channel region 121 is an example of a first channel region described in the claims. The channel region 122 is an example of a second channel region described in the claims.

The drain region 141 constitutes a common drain of the MOS transistors 22 and 21. Further, the drain region 142 constitutes a common drain of the MOS transistors 23 and 24. The drain regions 141 and 142 are placed adjacent to the channel regions 121 and 122, respectively. Note that the drain region 141 is an example of a first drain region described in the claims. The drain region 142 is an example of a second drain region described in the claims.

The gate electrode 131 constitutes the gates of the MOS transistors 22 and 23. The gate electrode 131 is placed on the surfaces of the channel regions 121 and 122 through an insulating film 171 (not shown). The gate electrode 131 in the figure represents an example placed in a shape surrounding the source region 101. The gate electrode 131 is formed by two gate electrodes formed on the surfaces of the channel regions 121 and 122, respectively, being joined together near the ends 161 and 162 of the source region 101.

The gate wire 163 is a wire connected to a joint of the gate electrode 131. The gate wire 163 in the figure is connected to the gate electrode 131 near the end 161 of the source region 101. The gate wire 163 is connected to the input signal line 14 and transmits an input signal to the gate electrodes of the MOS transistors 22 and 23. Note that the figure shows an example in which the gate electrode 131 and the gate wire 163 are coupled.

The drain electrode 151 is an electrode placed on the respective surfaces of the drain regions 141 and 142. The drain electrode 151 is formed by electrodes formed on the surfaces of the drain regions 141 and 142, respectively, being joined together near the end 162 of the source region 101. Specifically, the drain electrodes on the surfaces of the drain regions 141 and 142 are joined together near the end 162, which is the end on the side different from that of the end 161 near the connection between the gate electrode 131 and the gate wire 163, of the ends of the source region 101. Thus, the drain electrode 151 is formed in a shape bifurcated from the end 162 in two directions of the drain regions 141 and 142. Note that the end 161 is an example of a first source end described in the claims. The end 162 is an example of a second source end described in the claims.

The drain wire 164 is a wire connected to a joint of the drain electrode 151. The drain wire 164 is connected to the output signal line 15 and transmits a signal amplified by the MOS transistors 22 and 23. Note that the figure shows an example in which the drain electrode 151 and the drain wire 164 are coupled.

The channel region 123 is placed adjacent to the drain region 141 and constitutes the channel of the MOS transistor 21. The source region 102 is placed adjacent to the channel region 123 and constitutes the source of the MOS transistor 21. The source electrode 182 and the via plug 112 are formed in the source region 102. The gate electrode 133 is placed on the surface of the channel region 123 through an insulating film 172 (not shown) and constitutes the gate of the MOS transistor 21. The gate electrode 133 is connected to the gate wire 163 near the end 161. Note that the channel region 123 is an example of a third channel region described in the claims. The source region 102 is an example of a second source region described in the claims. The gate electrode 133 is an example of a second gate electrode described in the claims.

The channel region 124 is placed adjacent to the drain region 142 and constitutes the channel of the MOS transistor 24. The source region 103 is placed adjacent to the channel region 124 and constitutes the source of the MOS transistor 24. The source electrode 183 and the via plug 113 are formed in the source region 103. The gate electrode 134 is placed on the surface of the channel region 124 through an insulating film and constitutes the gate of the MOS transistor 24. Like the gate electrode 133, the gate electrode 133 is connected to the gate wire 163 near the end 161. Note that the channel region 124 is an example of a fourth channel region described in the claims. The source region 103 is an example of a third source region described in the claims. The gate electrode 134 is an example of a third gate electrode described in the claims.

As described above, in the semiconductor device 10 in the figure, the source region 101 is placed in the central part. The channel region 121, the drain region 141, the channel region 123, and the source region 102 are placed in this order adjacent to the one-side outer peripheral part of the source region divided by the ends 161 and 162. Further, the channel region 122, the drain region 142, the channel region 124, and the source region 103 are placed in this order adjacent to the other-side outer peripheral part of the source region 101. In this way, the MOS transistors 21 to 24 are formed in parallel. The gate electrodes 131, 133, and 134 are connected to the gate wire 163 near the end 161 of the source region 101 to be connected to the input signal line 14. The drain electrode 151 is connected to the drain wire 164 near the end 162 of the source region 101 to be connected to the output signal line 15.

Consequently, an input signal is distributed to the gate electrodes 131, 133, and 134 near the end 161. Further, output signals transmitted by the parts of the drain electrode 151 bifurcated in the directions of the drain regions 141 and 142 merge near the end 162. This can reduce skew in input signals and output signals in the MOS transistors 21 to 24. Furthermore, since the input signal line 14 and the output signal line 15 are placed apart by the semiconductor device 10, coupling between the input signal line 14 and the output signal line 15 can be reduced.

The source region 101 in the figure has the ends 161 and 162 smaller in width than the central part. The gate wire 163 and the drain wire 164 are placed near the ends 161 and 162, respectively. The channel region 121, the drain region 141, and the channel region 123, and the channel region 122, the drain region 142, and the channel region 124 are placed adjacent to each other along the outer periphery of the source region 101 having the ends made narrower. Consequently, the widths of the gate wire 163 and the drain wire 164 can be made smaller than the width of the central part of the source region 101. Further, in the figure, the width of the gate wire 163 (B in the figure) and the width of the drain wire 164 (C in the figure) can be made smaller than the width of the via plug 111 (A in the figure).

Thus, in the semiconductor device 10 in the figure, the multiple gate electrodes and drain electrodes adjacent to the source region 101 in which the via plug 111 having a relatively large shape is formed are bundled to be connected to the gate wire 163 and the drain wire 164 of relatively small widths, respectively. This can shorten the respective distances between the input signal line 14 and the output signal line 15 and the gate electrodes and the drain electrodes while placing the via plug 111 of a relatively large size. The efficiency of the amplifier circuit 1 operating in a millimeter-wave band can be improved.

Note that the configuration of the semiconductor device 10 is not limited to this example. For example, the gate electrode 131 may be divided at the end 162, that is, bifurcated in two directions from the end 161 like the drain electrode 151. Further, for the source region 101, one of the ends 161 and 162 may be made smaller in width than the central part.

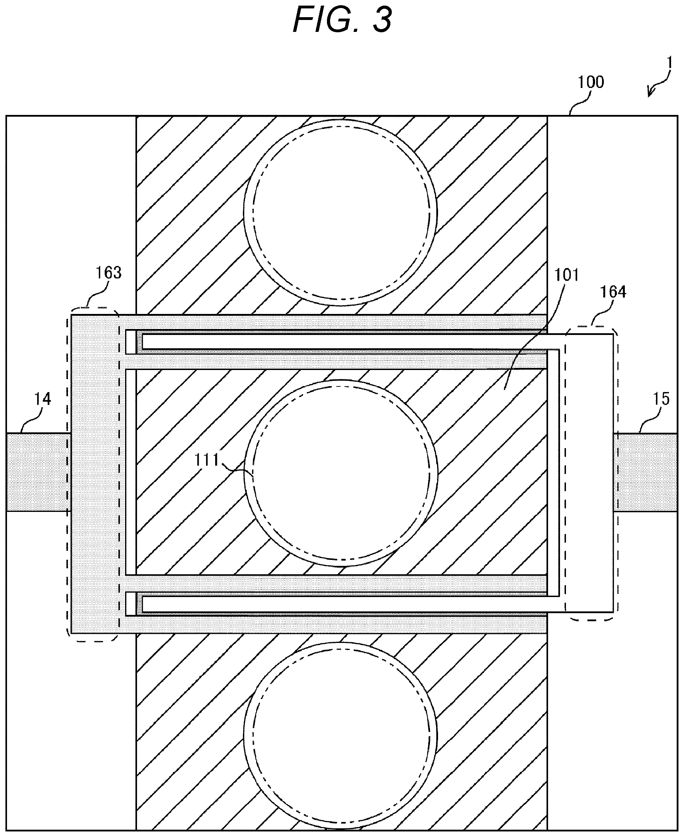

Fig. 3 is a diagram showing a configuration example of a conventional amplifier circuit. The figure is a diagram showing the conventional amplifier circuit as a comparative example. A semiconductor device 10 in the figure includes a rectangular source region 101. Gate electrodes and drain electrodes are wired at an angle of 90 degrees vertically and horizontally. Consequently, the widths of a gate wire 163 and a drain wire 164 are larger than the width of the source region 101. The distance from an input signal line 14 to the gate electrodes becomes long. Similarly, the distance from the drain electrodes to an output signal line 15 becomes long, increasing wiring resistance. Further, impedance changes at portions bent at a 90-degree angle, causing reflection. Moreover, a lot of unwanted emission is generated from 90-degree corners. These factors increase losses and decrease efficiency in the conventional amplifier circuit. By contrast, in the semiconductor device 10 in Fig. 2, wiring from the gate wire 163 to each gate electrode is diagonal wiring at an angle of 45 degrees. Wiring from each drain electrode to the drain wire 164 is likewise diagonal wiring at an angle of 45 degrees. Thus, in the semiconductor device 10 in Fig. 2, the wiring lengths can be shortened. Furthermore, reflection and the like at corners can be reduced. Losses can be reduced.

### [Cross-sectional configuration of semiconductor device]

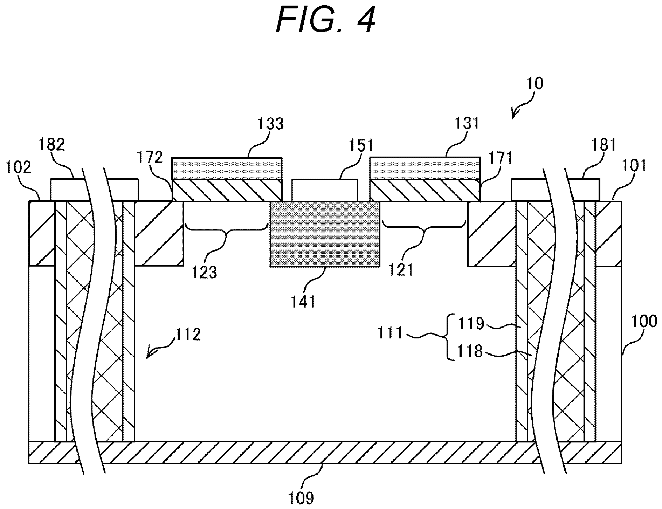

Fig. 4 is a diagram showing a configuration example of a semiconductor device according to the first embodiment of the present disclosure. The figure is a diagram showing a configuration example of the semiconductor device 10, and is a cross-sectional view taken along line D-D' in Fig. 2. As described above, the semiconductor device 10 is formed on the semiconductor substrate 100. The semiconductor substrate 100 may be made from, for example, silicon (Si). The source regions 101 and 102 and the drain region 141 are formed on the surface of the semiconductor substrate 100. The source regions 101 and 102 and the drain region 141 may be formed in a conductivity type different from that of the semiconductor substrate 100. For example, the semiconductor substrate 100 may be formed as a p-type semiconductor, and the source regions 101 and 102 and the drain region 141 may be formed as n-type semiconductors.

The gate electrode 131 is placed on the surface of the semiconductor substrate 100 between the source region 101 and the drain region 141 through the insulating film 171. Further, the gate electrode 133 is placed on the surface of the semiconductor substrate 100 between the source region 102 and the drain region 141 through the insulating film 172. The channel regions 121 and 123 are formed in the semiconductor substrate 100 under the gate electrodes 131 and 133, respectively. The drain electrode 151 is placed on the surface of the drain region 141.

The source electrode 181 and the via plug 111 and the source electrode 182 and the via plug 112 are placed in the source regions 101 and 102, respectively. The via plugs 111 and 112 each include a conductor 118 and an insulating layer 119 insulating the conductor 118. The source wire 109 is placed on the back surface of the semiconductor substrate 100, and is connected to the source electrodes 181 and 182 by the via plugs 111 and 112, respectively. The source wire 109 corresponds to the grounding conductor described in Fig. 1.

### [Modification 1]

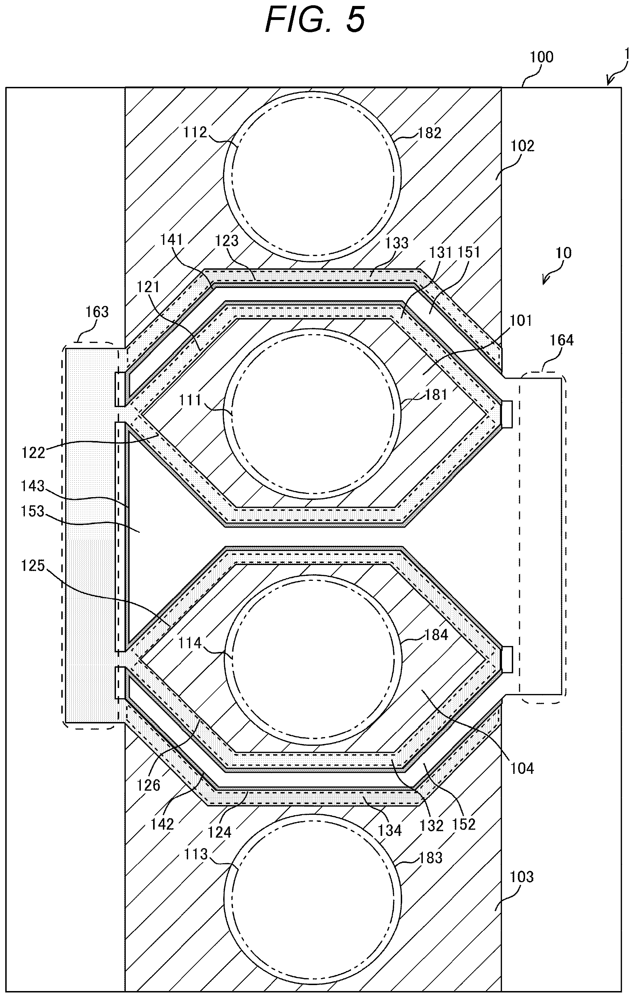

Fig. 5 is a diagram showing a configuration example of a semiconductor device according to a first modification of the first embodiment of the present disclosure. The semiconductor device 10 in the figure is different from the semiconductor device 10 described in Fig. 2 in that it further includes a source region 104 in the central part and a gate electrode 132 surrounding the source region 104. Channel regions 125 and 126 are placed adjacent to the source region 104, in which a source electrode 184 and a via plug 114 are placed. A drain region 143 is placed between the channel regions 122 and 125, and a drain electrode 153 is placed on the surface of the drain region 143. The gate electrode 132 is connected to the gate wire 163, and the drain electrode 153 is connected to the drain wire 164. Note that a drain electrode 152 is placed on the surface of the drain region 142 in the figure and is connected to the drain wire 164.

In this way, even in a case where the two source regions 101 and 104 are placed, the widths of the gate wire 163 and the drain wire 164 can be narrowed by making the ends of the source regions 101 and 104 narrower than the central parts.

### [Modification 2]

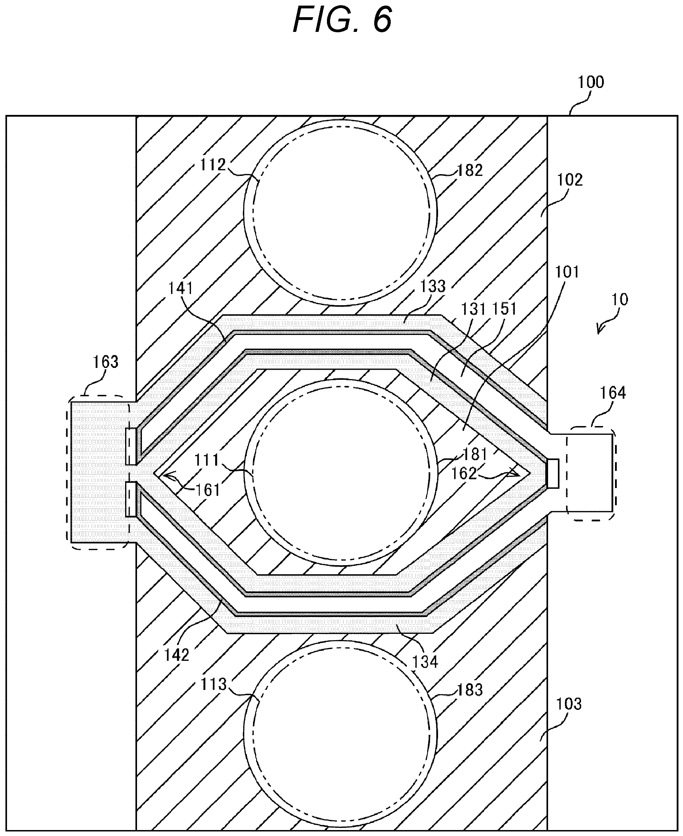

Fig. 6 is a diagram showing a configuration example of a semiconductor device according to a second modification of the first embodiment of the present disclosure. The semiconductor device 10 in the figure is different from the semiconductor device 10 described in Fig. 2 in that the ends 161 and 162 of the source region 101 are formed asymmetrically. The figure shows an example of the source region 101 with the end 162 tapered at a smaller angle than the end 161. Note that in the figure, the description of channel regions is omitted.

### [Modification 3]

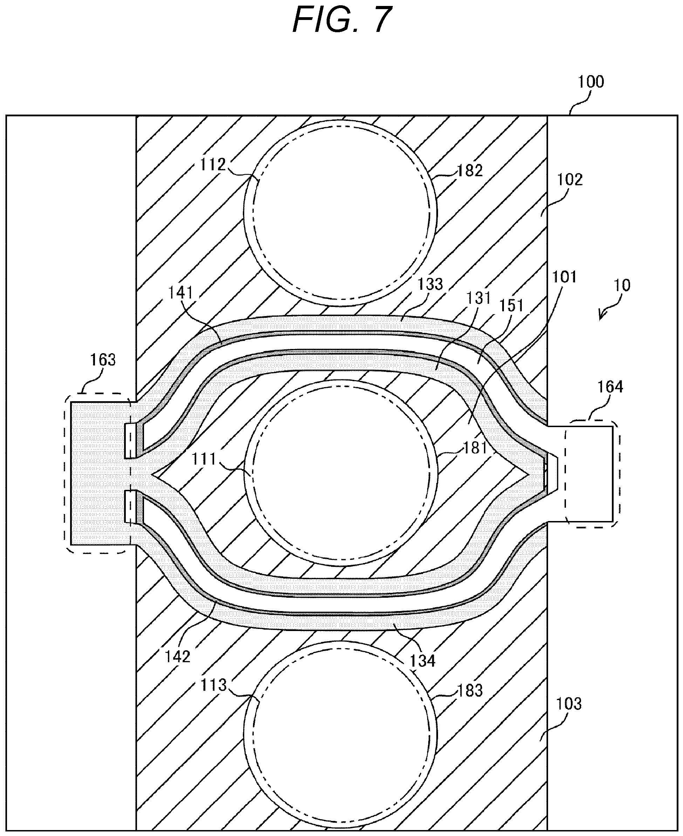

Fig. 7 is a diagram showing a configuration example of a semiconductor device according to a third modification of the first embodiment of the present disclosure. The semiconductor device 10 in the figure is different from the semiconductor device 10 described in Fig. 2 in that the outer periphery of the source region 101 is curved. Further, for the gate electrodes 131, 133, and 134, the drain regions 141 and 142, and the drain electrode 151 in the figure, their outer peripheries are also curved. In this case as well, the ends 161 and 162 are formed with a width smaller than the width of the central part of the source region 101. Since the gate electrodes 131, 133, and 134 and the drain electrode 151 are formed in curved shapes, losses can be further reduced. Note that in the figure, the description of channel regions is omitted.

### [Modification 4]

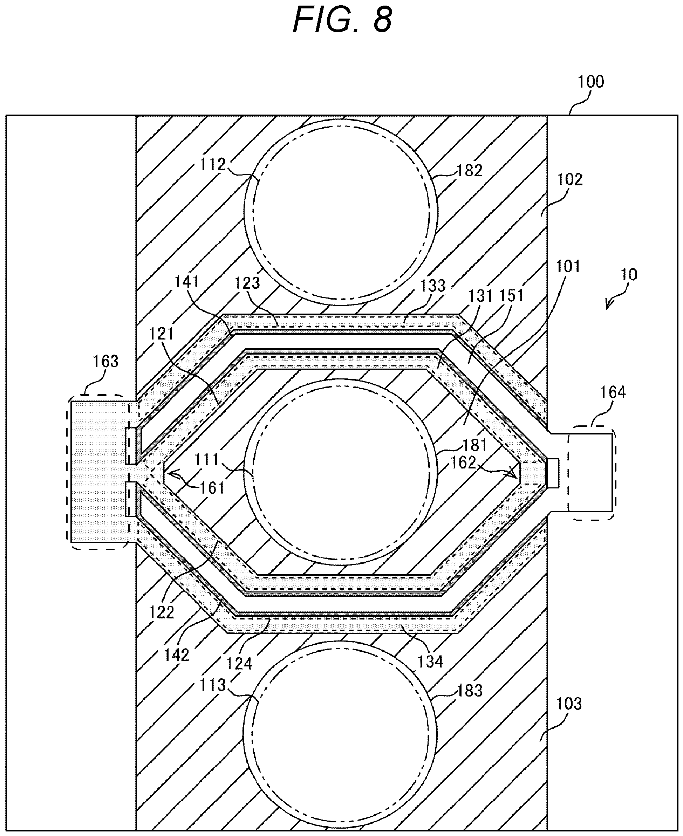

Fig. 8 is a diagram showing a configuration example of a semiconductor device according to a fourth modification of the first embodiment of the present disclosure. The semiconductor device 10 in the figure is different from the semiconductor device 10 described in Fig. 2 in that the ends 161 and 162 of the source region 101 are formed by sides. In this case as well, the ends 161 and 162 are formed with a width smaller than the width of the central part of the source region 101.

As described above, in the semiconductor device 10 of the first embodiment of the present disclosure, both ends of the source region 101 are made smaller in width than the central part, and the width of at least one of the gate wire 163 or the drain wire 164 is made smaller than the width of the central part of the source region 101. This can shorten the wiring length of at least one of the gates and the drains to reduce losses.

### <2. Second embodiment>

The semiconductor device 10 in the first embodiment described above includes four channel regions. In contrast, a semiconductor device 10 of a second embodiment of the present disclosure is different from that in the above-described first embodiment in that it includes two channel regions.

### [Configuration of semiconductor device]

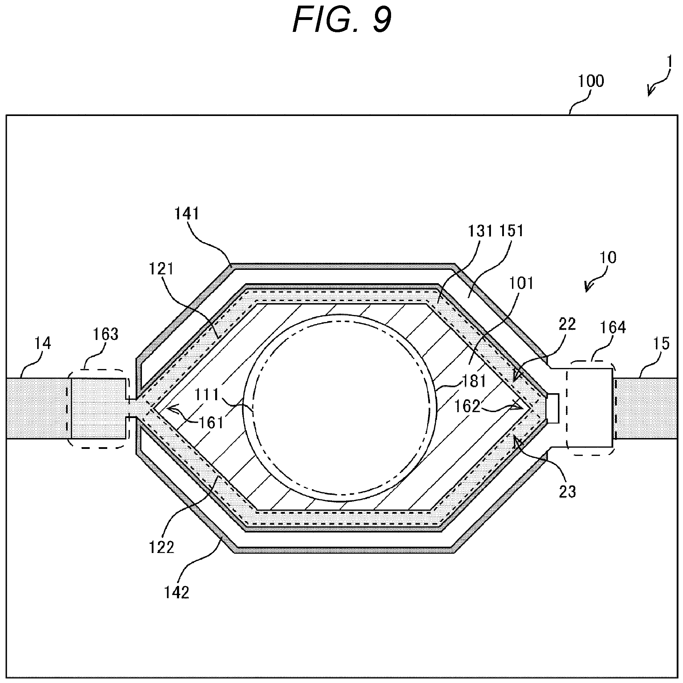

Fig. 9 is a diagram showing a configuration example of an amplifier circuit according to the second embodiment of the present disclosure. The semiconductor device 10 in the figure is different from the semiconductor device 10 described in Fig. 2 in that the channel regions 123 and 124, the gate electrodes 133 and 134, the source regions 102 and 103, and the via plugs 112 and 113 are eliminated.

The semiconductor device 10 in the figure corresponds to a semiconductor device including the MOS transistors 22 and 23 corresponding to the two channel regions 121 and 122. In the semiconductor device 10 in the figure as well, the widths of the gate wire 163 and the drain wire 164 can be made smaller than the width of the central part of the source region 101.

### [Modification 5]

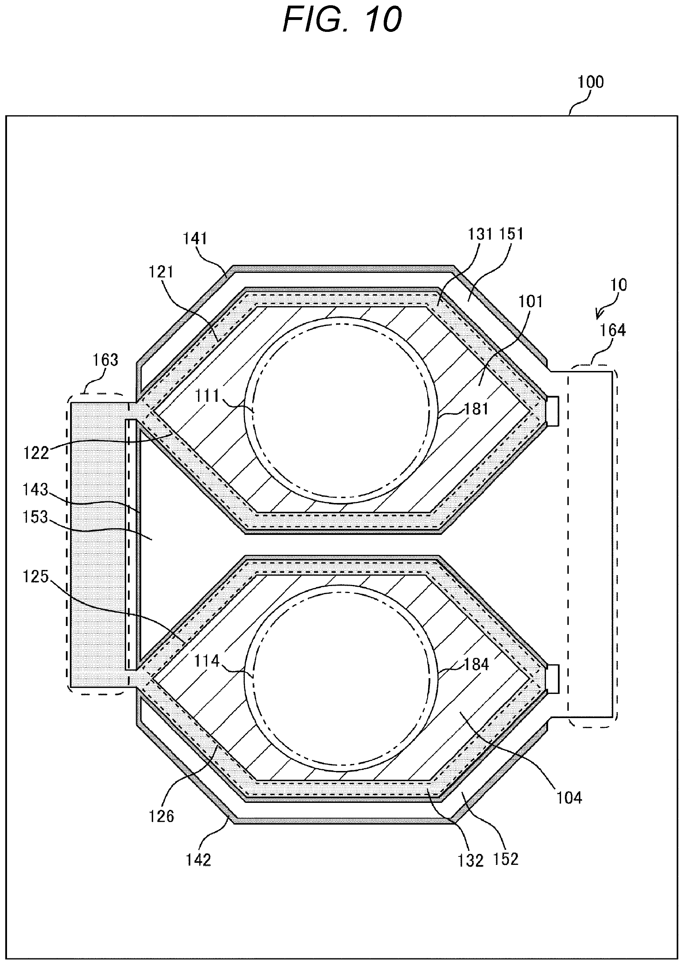

Fig. 10 is a diagram showing a configuration example of a semiconductor device according to a modification of the second embodiment of the present disclosure. The semiconductor device 10 in the figure is different from the semiconductor device 10 described in Fig. 9 in that it further includes a source region 104 in the central part and a gate electrode 132 surrounding the source region 104. Channel regions 125 and 126 are placed adjacent to the source region 104, in which a source electrode 184 and a via plug 114 are placed. A drain region 143 is placed between the channel regions 122 and 125, and a drain electrode 153 is placed on the surface of the drain region 143. The gate electrode 132 is connected to the gate wire 163, and the drain electrode 153 is connected to the drain wire 164. A drain electrode 152 is placed on the surface of the drain region 142 in the figure and is connected to the drain wire 164. In the semiconductor device 10 in the figure as well, the widths of the gate wire 163 and the drain wire 164 can be narrowed by making the ends of the source regions 101 and 104 narrower than the central parts.

The other configuration of the amplifier circuit 1 is similar to the configuration of the amplifier circuit 1 described in the first embodiment of the present disclosure, and thus will not be described.

As described above, in the semiconductor device 10 of the second embodiment of the present disclosure, the wiring lengths of the gates and the drains can be shortened in the semiconductor device 10 including the two channel regions 121 and 122. This can reduce losses in the semiconductor device 10.

### <3. Third embodiment>

The amplifier circuit 1 of the first embodiment described above includes four MOS transistors. In contrast, an amplifier circuit 1 of a third embodiment of the present disclosure is different from that of the above-described first embodiment in that it includes eight MOS transistors.

### [Circuit configuration]

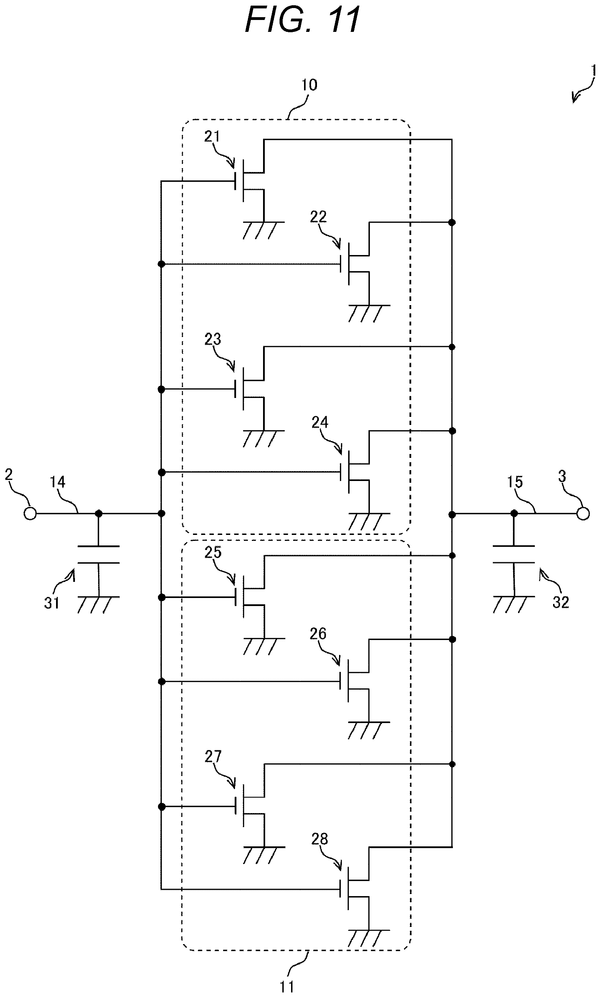

Fig. 11 is a circuit diagram showing a configuration example of an amplifier circuit according to the third embodiment of the present disclosure. The amplifier circuit 1 in the figure is different from the amplifier circuit 1 described in Fig. 1 in that it further includes a semiconductor device 11 (MOS transistors 25 to 28) and further includes capacitors 31 and 32 as circuit elements. The gates of the MOS transistors 25, 26, 27, and 28 are connected to the input signal line 14 together. The sources of the MOS transistors 25, 26, 27, and 28 are connected to the grounding conductor. The drains of the MOS transistors 25, 26, 27, and 28 are connected to the output signal line 15 together. The capacitor 31 is connected between the input signal line 14 and the grounding conductor, and the capacitor 32 is connected between the output signal line 15 and the grounding conductor. The other connections are similar to those in Fig. 1, and thus will not be described.

As shown in the figure, the MOS transistors 21 to 28 are connected in parallel to amplify a signal input to their respective gates. Furthermore, the capacitors 31 and 32 are capacitors for impedance matching. The MOS transistors 25 to 28 constitute the semiconductor device 11.

### [Configuration of semiconductor device]

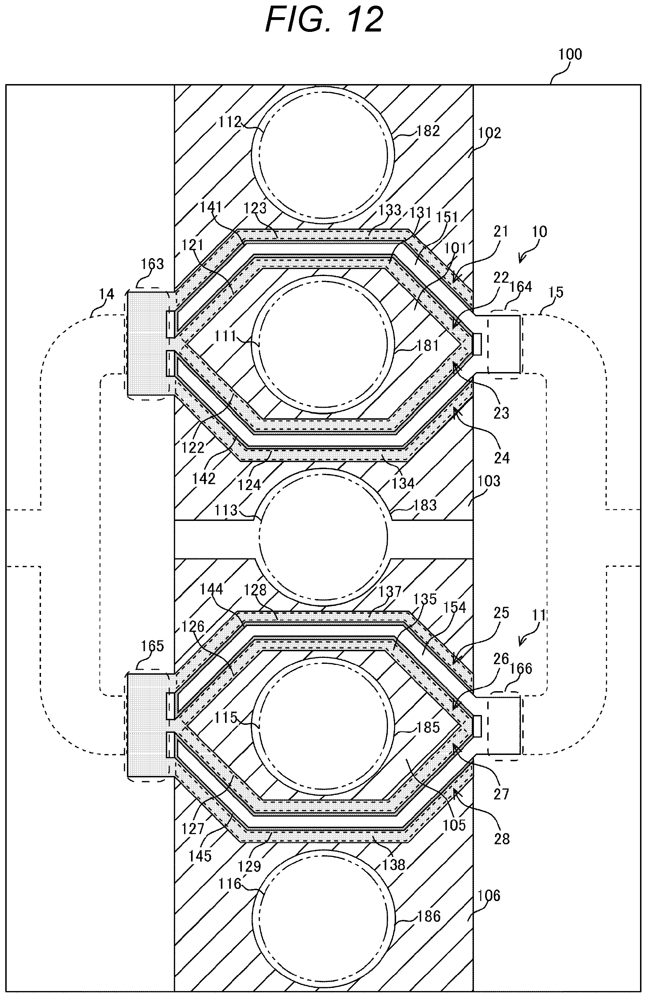

Fig. 12 is a diagram showing a configuration example of semiconductor devices according to the third embodiment of the present disclosure. The figure is a diagram showing the configuration of the semiconductor devices 10 and 11. The semiconductor device 11 includes source regions 103, 105, and 106, channel regions 126 to 129, drain regions 144 and 145, gate electrodes 135, 137, and 138, a gate wire 165, and a drain electrode 154. Furthermore, the semiconductor device 11 further includes a drain wire 166, source electrodes 183, 185, and 186, and via plugs 113, 115, and 116.

Note that the source region 103 is shared between the semiconductor devices 10 and 11. Specifically, the source region 103 is placed adjacent to the channel region 124 of the semiconductor device 10 and the channel region 128 of the semiconductor device 11, and constitutes a common source region in the MOS transistors 24 and 25 corresponding to the respective channel regions. Consequently, the occupied area on the semiconductor substrate can be reduced as compared with a case where two semiconductor devices are placed separately.

Furthermore, the source electrode 183 in the figure is formed in a shape having an added rectangular pattern extended to the ends of the source region 103. This is to connect the capacitors 31 and 32 at the ends of the source region 103. The gate wires 163 and 165 are connected to the input signal line 14 together. Similarly, the drain wires 164 and 166 are connected to the output signal line 15 together.

Note that the channel regions 124 and 128 in the figure are an example of a fifth channel region described in the claims. The gate electrodes 134 and 137 in the figure are an example of a fourth gate electrode described in the claims. The source region 103 in the figure is an example of a common source region described in the claims. The source electrode 183 is an example of a source electrode described in the claims.

### [Configuration of amplifier circuit]

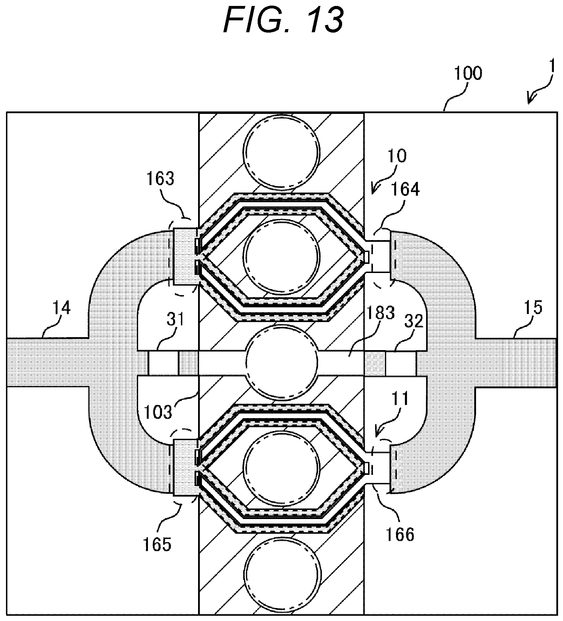

Fig. 13 is a diagram showing a configuration example of the amplifier circuit according to the third embodiment of the present disclosure. The amplifier circuit 1 in the figure is a circuit formed using the semiconductor devices 10 and 11 described in Fig. 12.

The capacitor 31 is placed between the gate wires 163 and 165 and the input signal line 14, and is connected between a portion of the input signal line 14 bifurcated to the gate wires 163 and 165 and the source electrode 183. The capacitor 32 is placed between the drain wires 164 and 166 and the output signal line 15, and is connected between a portion of the output signal line 15 bifurcated to the drain wires 164 and 166 and the source electrode 183. The capacitor 31 needs to be placed at a specified distance from the gate electrodes 134 and 137 and the gate wires 163 and 165. This is to reduce electromagnetic coupling with signal wiring. For a similar reason, the capacitor 32 is also placed at a specified distance from the gate electrodes 134 and 137 and the drain wires 164 and 166.

Since the ends of the source regions 101 and 105 are made smaller in width than the central parts in the semiconductor devices 10 and 11 in the figure, the widths of the gate wires 163 and 165 and the drain wires 164 and 166 can be narrowed. Furthermore, the gate electrodes 134 and 137 can be placed obliquely toward the gate wires 163 and 165. The drain electrodes 151 and 154 can also be placed obliquely toward the drain wires 164 and 166. Consequently, relatively large spaces can be provided near the ends of the semiconductor devices 10 and 11. By placing the capacitors 31 and 32 in the spaces, the amplifier circuit 1 can be miniaturized while ensuring the above-mentioned distances.

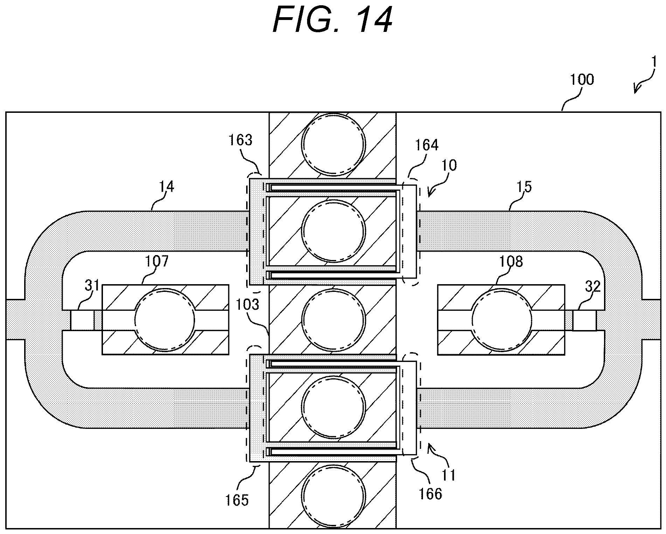

Fig. 14 is a diagram showing a configuration example of a conventional amplifier circuit. The figure is a diagram shown as a comparative example, and is a diagram showing an amplifier circuit 1 using semiconductor devices described in Fig. 3. In the semiconductor device 10 in the figure, the gate wire 163 and the drain wire 164 are formed with substantially the same width as the width of the semiconductor device 10. Similarly, in a semiconductor device 11, a gate wire 165 and a drain wire 166 are formed with substantially the same width as the width of the semiconductor device 11. Consequently, a specified distance from the gate wire 165 and others cannot be provided, and capacitors 31 and 32 cannot be placed near the source region 103. Additional source regions 107 and 108 are placed to connect the capacitors 31 and 32, respectively, increasing the wiring lengths of the input signal line 14 and the output signal line 15. Furthermore, the area occupied by the amplifier circuit 1 increases.

Note that the configuration of the amplifier circuit 1 is not limited to this example. For example, in place of the capacitors 31 and 32, which are circuit elements, other impedance elements may be used. Here, the impedance elements correspond to, for example, resistors, capacitors, inductors, or composite elements of them.

The other configuration of the amplifier circuit 1 is similar to the configuration of the amplifier circuit 1 described in the first embodiment of the present disclosure, and thus will not be described.

As described above, in the amplifier circuit 1 of the third embodiment of the present disclosure, spaces in which to place circuit elements can be provided near the semiconductor devices 10 and 11 by making the ends of the source regions 101 and 105 of the semiconductor devices 10 and 11 narrower than the central parts. This allows the amplifier circuit 1 to be miniaturized.

### <4. Fourth embodiment>

The amplifier circuit 1 of the third embodiment described above uses the capacitors 31 and 32 as circuit elements. In contrast, an amplifier circuit 1 of a fourth embodiment of the present disclosure is different from that of the above-described third embodiment in that short stubs are used as circuit elements.

### [Configuration of amplifier circuit]

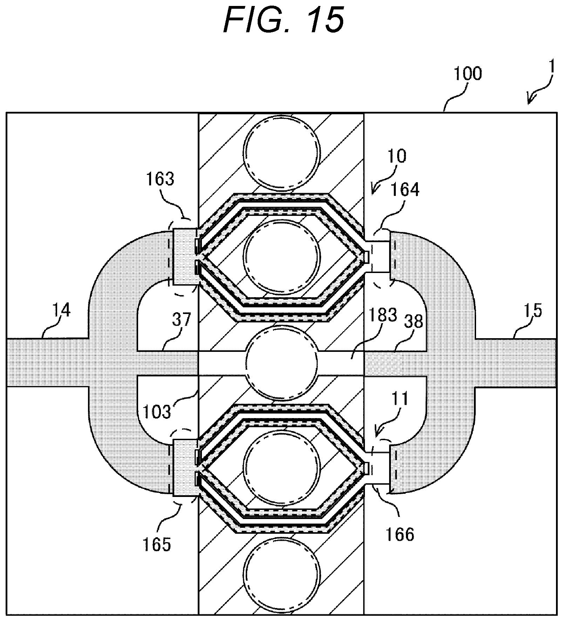

Fig. 15 is a circuit diagram showing an example of an amplifier circuit according to the fourth embodiment of the present disclosure. The amplifier circuit 1 in the figure is different from the amplifier circuit 1 described in Fig. 13 in that it includes short stubs 37 and 38 instead of the capacitors 31 and 32. Here, the short stubs are short-circuited distributed constant circuits. The short stubs 37 and 38 in the figure are formed by wires making short-circuits between the input signal line 14 and the output signal line 15 and the source electrode 183.

The other configuration of the amplifier circuit 1 is similar to the configuration of the amplifier circuit 1 described in the third embodiment of the present disclosure, and thus will not be described.

As described above, the amplifier circuit 1 of the fourth embodiment of the present disclosure allows miniaturization of the amplifier circuit 1 in which the short stubs 37 and 38 are placed.

### <5. Fifth embodiment>

The amplifier circuit 1 of the third embodiment described above includes the two semiconductor devices 10 and 11. In contrast, an amplifier circuit 1 of a fifth embodiment of the present disclosure is different from that of the above-described third embodiment in that it includes four semiconductor devices.

### [Circuit configuration]

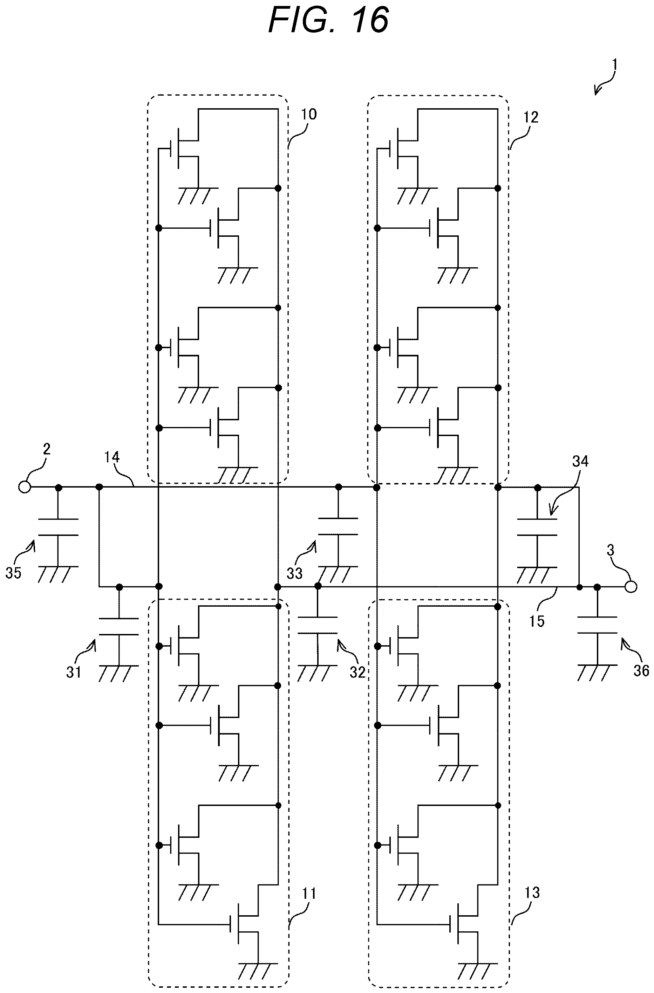

Fig. 16 is a circuit diagram showing a configuration example of an amplifier circuit according to the fifth embodiment of the present disclosure. The amplifier circuit 1 in the figure is different from the amplifier circuit 1 described in Fig. 11 in that it further includes semiconductor devices 12 and 13 and capacitors 33 to 36. The gates and drains of MOS transistors included in the semiconductor devices 12 and 13 are connected to the input signal line 14 and the output signal line 15 together, respectively. The sources of the MOS transistors included in the semiconductor devices 12 and 13 are connected to the grounding conductor. The capacitors 33 and 35 are wired between the input signal line 14 and the grounding conductor. The capacitors 34 and 36 are wired between the output signal line 15 and the grounding conductor. The other connections are similar to those in Fig. 11, and thus will not be described.

As shown in the figure, the MOS transistors included in the semiconductor devices 10 to 13 are connected in parallel to amplify a signal input to their respective gates. Furthermore, the capacitors 31 to 36 are capacitors for impedance matching.

### [Configuration of amplifier circuit]

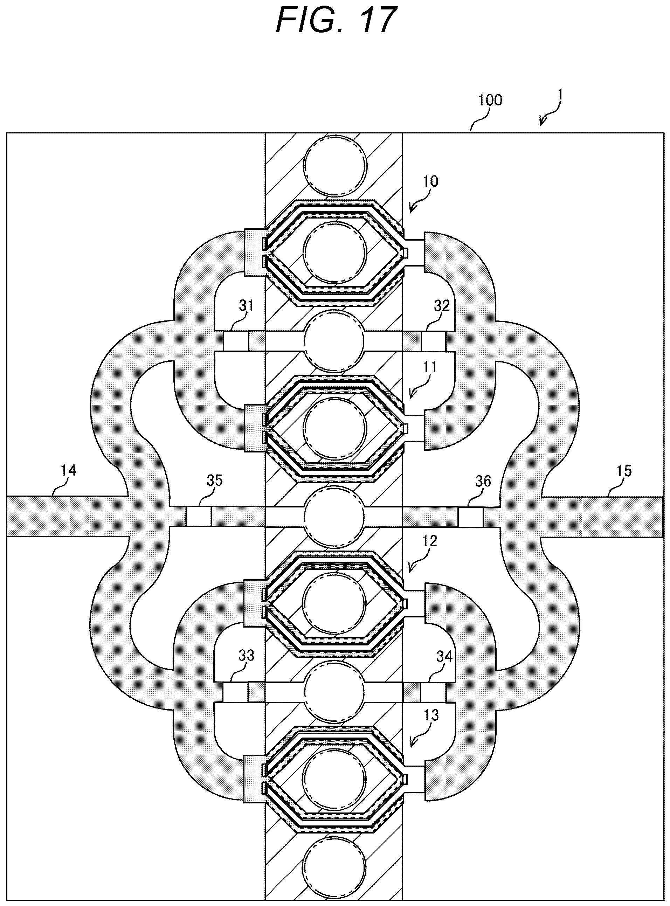

Fig. 17 is a diagram showing a configuration example of the amplifier circuit according to the fifth embodiment of the present disclosure. As shown in the figure, the semiconductor devices 10 to 13 are placed adjacently in this order. The input signal line 14 is bifurcated twice from the input terminal to be connected to the gate wires of the semiconductor devices 10 to 13. Similarly, the output signal line 15 is bifurcated twice from the output terminal to be connected to the drain wires of the semiconductor devices 10 to 13. The capacitors 33 and 34 are placed near the semiconductor devices 12 and 13. The capacitor 35 is placed between the semiconductor devices 11 and 12 and the input signal line 14. The capacitor 36 is placed between the semiconductor devices 11 and 12 and the output signal line 15.

The other configuration of the amplifier circuit 1 is similar to the configuration of the amplifier circuit 1 described in the third embodiment of the present disclosure, and thus will not be described.

As described above, in the amplifier circuit 1 of the fifth embodiment of the present disclosure, spaces in which to place circuit elements can be provided near the semiconductor devices 10 to 13 by making the ends of the source regions of the semiconductor devices 10 to 13 narrower than the central parts. This allows the amplifier circuit 1 to be miniaturized.

### <6. Sixth embodiment>

The amplifier circuit 1 of the first embodiment described above uses MOS transistors made from Si. In contrast, an amplifier circuit 1 of a sixth embodiment of the present disclosure is different from that of the above-described first embodiment in that it uses MOS transistors made from gallium nitride (GaN).

### [Cross-sectional configuration of semiconductor device]

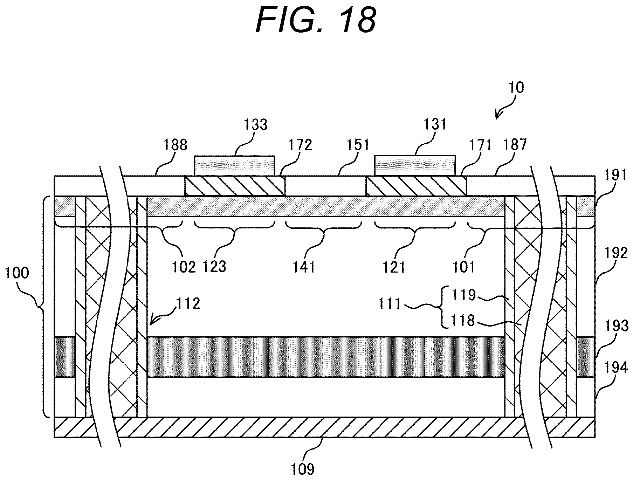

Fig. 18 is a diagram showing a configuration example of a semiconductor device according to the sixth embodiment of the present disclosure. Similar to Fig. 4, the figure is a cross-sectional view showing a configuration example of a semiconductor device 10. The semiconductor device 10 in the figure is different from the semiconductor device 10 described in Fig. 4 in that it uses a semiconductor substrate 100 made from GaN.

The semiconductor substrate 100 in the figure includes a Si substrate 194, a buffer layer 193, a GaN layer 192, and a channel layer 191 stacked on top of each other in this order. A semiconductor layer made from a mixed crystal of aluminum nitride (AlN) and GaN may be used as the channel layer 191. The insulating films 172 and 171 are placed adjacent to the channel layer 191, on which the gate electrodes 131 and 133 are placed in layers, respectively.

The source regions 101 and 102 are formed in the channel layer 191. Specifically, source electrodes 187 and 188 are placed adjacent to the channel layer 191. The channel layer 191 immediately below the source electrodes 187 and 188 is used as the source regions 101 and 102. The via plugs 111 and 112 are formed between the source electrodes 187 and 188 and the source wire 109.

The other configuration of the amplifier circuit 1 is similar to the configuration of the amplifier circuit 1 described in the first embodiment of the present disclosure, and thus will not be described.

As described above, the amplifier circuit 1 of the sixth embodiment of the present disclosure allows miniaturization of the amplifier circuit 1 even in a case of using a semiconductor device made from GaN.

Finally, the description of each embodiment described above is an example of the present disclosure, and the present disclosure is not limited to the above-described embodiments. Therefore, it goes without saying that in addition to the above-described embodiments, various changes can be made depending on design and the like without departing from the scope of the claims.

### REFERENCE SIGNS LIST

1 Amplifier circuit
2 Input terminal
3 Output terminal
10 to 13 Semiconductor device
14 Input signal line
15 Output signal line
21 to 28 MOS transistor
31 to 36 Capacitor
37 Short stub
100 Semiconductor substrate
101 to 108 Source region
109 Source wire
111 to 116 Via plug
121 to 129 Channel region
131 to 138 Gate electrode
141 to 145 Drain region
151 to 154 Drain electrode
161, 162 End
163, 165 Gate wire
164, 166 Drain wire
171, 172 Insulating film
181 to 188 Source electrode

## Claims

1. A semiconductor device (10) comprising:
a source region (101) placed on a semiconductor substrate (100) and having both ends (161, 162) made smaller in width than a central part in a plan view;
a first channel region (121) and a second channel region (122) placed adjacent to corresponding outer peripheral parts of the source region divided, in the plan view, by the both ends on the semiconductor substrate;
a first drain region (141) and a second drain region (142) placed, in the plan view, adjacent to the first channel region and the second channel region, respectively, on the semiconductor substrate;
gate electrodes (131) placed on respective surfaces of the first channel region and the second channel region through an insulating film and joined to each other near a first source end that is one of the ends of the source region;
a gate wire (163) for transmitting an input signal to the gate electrodes connected to a portion where the gate electrodes are joined;
drain electrodes (151) placed on respective surfaces of the first drain region and the second drain region and joined to each other near a second source end that is another of the ends of the source region different from the first source end; and
a drain wire (164) for transmitting an output signal from the drain electrodes connected to a portion where the drain electrodes are joined,
wherein, in the plan view, at least one of the gate wire or the drain wire is made smaller in width than the central part of the source region; wherein the semiconductor device further comprises:
a third channel region (123) placed, in the plan view, adjacent to the first drain region;
a second source region (102) placed, in the plan view, adjacent to the third channel region;
a second gate electrode (133) placed on a surface of the third channel region through an insulating film and connected to the gate wire;
a fourth channel region (124) placed, in the plan view, adjacent to the second drain region;
a third source region (103) placed, in the plan view, adjacent to the fourth channel region; and
a third gate electrode (134) placed on a surface of the fourth channel region through an insulating film and connected to the gate wire.

2. The semiconductor device according to claim 1, further comprising:
a via plug (111) formed in the source region and extending through the semiconductor substrate; and
a source wire (181) connected to the source region through the via plug.

3. The semiconductor device according to claim 2, wherein at least one of the gate wire or the drain wire is made smaller in width than the via plug.

4. The semiconductor device according to claim 1, wherein the source region is formed in a tapered shape at each of the both ends.

5. The semiconductor device according to claim 4, wherein the source region is formed in a tapered shape with an angle of approximately 90 degrees at the both ends.

6. An electronic circuit (1) comprising:
at least one semiconductor device according to claim 1;
an input signal line connected to the gate wire of the at least one semiconductor device to transmit the input signal; and
an output signal line connected to the drain wire of the at least one semiconductor device to transmit the output signal.

7. The electronic circuit according to claim 6, wherein
the at least one semiconductor device further comprises:
a fifth channel region placed adjacent to the first drain region; and
a fourth gate electrode placed on a surface of the fifth channel region through an insulating film and connected to the gate wire.

8. The electronic circuit according to claim 7, wherein
the at least one semiconductor device comprises two semiconductor devices,
the electronic circuit further comprises a common source region placed adjacent to both the respective fifth channel regions of the two semiconductor devices,
the input signal line is connected to both the respective gate wires of the two semiconductor devices to transmit an input signal, and
the output signal line is connected to both the respective drain wires of the two semiconductor devices to transmit an output signal.

9. The electronic circuit according to claim 8, further comprising:
a source electrode placed on a surface of the common source region; and
a circuit element connected between the source electrode and at least one of the input signal line or the output signal line.

10. The electronic circuit according to claim 9, wherein the circuit element is an impedance element.

11. The electronic circuit according to claim 10, wherein the impedance element is formed by a resistor, an inductor, or a capacitor.

12. The electronic circuit according to claim 9, wherein the circuit element is a short stub.

## Patentansprüche

1. Halbleitervorrichtung (10), umfassend:
einen Source-Bereich (101), der auf einem Halbleitersubstrat (100) angeordnet ist und dessen beide Enden (161, 162) in der Draufsicht schmaler ausgebildet sind als ein zentraler Teil;
einen ersten Kanalbereich (121) und einen zweiten Kanalbereich (122), die neben entsprechenden äußeren Randteilen des Source-Bereichs angeordnet sind, der in der Draufsicht durch die beiden Enden auf dem Halbleitersubstrat geteilt ist;
einen ersten Drain-Bereich (141) und einen zweiten Drain-Bereich (142), die in der Draufsicht neben dem ersten Kanalbereich bzw. dem zweiten Kanalbereich auf dem Halbleitersubstrat platziert sind;
Gate-Elektroden (131), die auf jeweiligen Oberflächen des ersten Kanalbereichs und des zweiten Kanalbereichs durch einen Isolierfilm hindurch platziert und nahe einem ersten Source-Ende, das eines der Enden des Source-Bereichs ist, miteinander verbunden sind;
einen Gate-Draht (163) zum Übertragen eines Eingangssignals an die Gate-Elektroden, der mit einem Abschnitt verbunden ist, an dem die Gate-Elektroden verbunden sind;
Drain-Elektroden (151), die auf jeweiligen Oberflächen des ersten Drain-Bereichs und des zweiten Drain-Bereichs platziert und nahe einem zweiten Source-Ende miteinander verbunden sind, das ein anderes Ende des Source-Bereichs ist, das sich vom ersten Source-Ende unterscheidet; und
einen Drain-Draht (164) zum Übertragen eines Ausgangssignals von den Drain-Elektroden, der mit einem Abschnitt verbunden ist, an dem die Drain-Elektroden verbunden sind,
wobei in der Draufsicht mindestens einer von dem Gate-Draht oder dem Drain-Draht mit einer geringeren Breite ausgeführt ist als der zentrale Teil des Source-Bereichs; wobei die Halbleitervorrichtung ferner umfasst:
einen dritten Kanalbereich (123), der in der Draufsicht neben dem ersten Drain-Bereich platziert ist;
einen zweiten Source-Bereich (102), der in der Draufsicht neben dem dritten Kanalbereich platziert ist;
eine zweite Gate-Elektrode (133), die durch einen Isolierfilm hindurch auf einer Oberfläche des dritten Kanalbereichs platziert und mit dem Gate-Draht verbunden ist;
einen vierten Kanalbereich (124), der in der Draufsicht neben dem zweiten Drain-Bereich platziert ist;
einen dritten Source-Bereich (103), der in der Draufsicht neben dem vierten Kanalbereich platziert ist; und
eine dritte Gate-Elektrode (134), die durch einen Isolierfilm hindurch auf einer Oberfläche des vierten Kanalbereichs platziert und mit dem Gate-Draht verbunden ist.

2. Halbleitervorrichtung nach Anspruch 1, ferner umfassend:
einen Via-Stecker (111), der im Source-Bereich ausgebildet ist und sich durch das Halbleitersubstrat erstreckt; und
einen Source-Draht (181), der über den Via-Stecker mit dem Source-Bereich verbunden ist.

3. Halbleiterbauelement nach Anspruch 2, wobei mindestens einer von dem Gate-Draht oder dem Drain-Draht mit einer geringeren Breite ausgeführt ist als der Via-Stecker.

4. Halbleitervorrichtung nach Anspruch 1,
wobei der Source-Bereich an beiden Enden jeweils eine konische Form aufweist.

5. Halbleitervorrichtung nach Anspruch 4, wobei der Source-Bereich eine sich verjüngende Form mit einem Winkel von ungefähr 90 Grad an beiden Enden aufweist.

6. Elektronische Schaltlogik (1), umfassend:
mindestens eine Halbleitervorrichtung nach Anspruch 1;
eine Eingangssignalleitung, die mit dem Gate-Draht der mindestens einen Halbleitervorrichtung verbunden ist, um das Eingangssignal zu übertragen; und
eine Ausgangssignalleitung, die mit dem Drain-Draht der mindestens einen Halbleitervorrichtung verbunden ist, um das Ausgangssignal zu übertragen.

7. Elektronische Schaltlogik nach Anspruch 6, wobei
die mindestens eine Halbleitervorrichtung ferner umfasst:
einen fünften Kanalbereich, der neben dem ersten Drain-Bereich platziert ist; und
eine vierte Gate-Elektrode, die durch einen Isolierfilm auf einer Oberfläche des fünften Kanalbereichs platziert und mit dem Gate-Draht verbunden ist.

8. Elektronische Schaltlogik nach Anspruch 7, wobei
die mindestens eine Halbleitervorrichtung zwei Halbleitervorrichtungen umfasst,
die elektronische Schaltlogik ferner einen gemeinsamen Source-Bereich umfasst, der benachbart zu den jeweiligen fünften Kanalbereichen der beiden Halbleitervorrichtungen angeordnet ist,
die Eingangssignalleitung mit den jeweiligen Gate-Drähten der beiden Halbleitervorrichtungen verbunden ist, um ein Eingangssignal zu übertragen, und
die Ausgangssignalleitung mit den jeweiligen Drain-Drähten der beiden Halbleitervorrichtungen verbunden ist, um ein Ausgangssignal zu übertragen.

9. Elektronische Schaltlogik nach Anspruch 8,
ferner umfassend:
eine Source-Elektrode, die auf einer Oberfläche des gemeinsamen Source-Bereichs platziert ist; und
ein Schaltungselement, das zwischen der Source-Elektrode und mindestens einer der Eingangssignalleitung oder der Ausgangssignalleitung angeschlossen ist.

10. Elektronische Schaltlogik nach Anspruch 9, wobei das Schaltungselement ein Impedanzelement ist.

11. Elektronische Schaltlogik nach Anspruch 10, wobei das Impedanzelement durch einen Widerstand, eine Induktivität oder einen Kondensator gebildet ist.

12. Elektronische Schaltlogik nach Anspruch 9, wobei das Schaltungselement eine kurze Stichleitung ist.

## Revendications

1. Dispositif semi-conducteur (10) comprenant :
une région source (101) placée sur un substrat semi-conducteur (100) et ayant les deux extrémités (161, 162) qui ont une largeur inférieure à celle de la partie centrale dans une vue de plan ;
une première région de canal (121) et une deuxième région de canal (122) placées de manière adjacente aux parties périphériques extérieures correspondantes de la région source divisée, dans la vue de plan, par les deux extrémités sur le substrat semi-conducteur ;
une première région de drain (141) et une seconde région de drain (142) placées, dans la vue de plan, à côté de la première région de canal et de la deuxième région de canal, respectivement, sur le substrat semi-conducteur ;
des électrodes de grille (131) placées sur les surfaces respectives de la première région de canal et de la deuxième région de canal à travers un film isolant et reliées l'une à l'autre près d'une première extrémité de source qui est l'une des extrémités de la région source ;
un fil de grille (163) pour transmettre un signal d'entrée aux électrodes de grille connectées à une partie où les électrodes de grille sont reliées ;
des électrodes de drain (151) placées sur les surfaces respectives de la première région de drain et de la seconde région de drain et reliées l'une à l'autre près d'une seconde extrémité de source qui est une autre des extrémités de la région source différente de la première extrémité de source ; et
un fil de drain (164) pour transmettre un signal de sortie des électrodes de drain connecté à une partie où les électrodes de drain sont reliées,
dans lequel, dans la vue de plan, au moins l'un des fil de grille ou fil de drain a une largeur inférieure à celle de la partie centrale de la région source ; dans lequel le dispositif semi-conducteur comprend en outre :
une troisième région de canal (123) placée, dans la vue de plan, à côté de la première région de drain ;
une deuxième région source (102) placée, dans la vue de plan, à côté de la troisième région de canal ;
une deuxième électrode de grille (133) placée sur une surface de la troisième région de canal à travers un film isolant et connectée au fil de grille ;
une quatrième région de canal (124) placée, dans la vue de plan, à côté de la seconde région de drain ;
une troisième région source (103) placée, dans la vue de plan, à côté de la quatrième région de canal ; et
une troisième électrode de grille (134) placée sur une surface de la quatrième région de canal à travers un film isolant et connectée au fil de grille.

2. Dispositif semi-conducteur selon la revendication 1, comprenant en outre :
un bouchon de passage (111) formé dans la région source et s'étendant à travers le substrat semi-conducteur ; et
un fil de source (181) connecté à la région source par l'intermédiaire du bouchon de passage.

3. Dispositif semi-conducteur selon la revendication 2, dans lequel au moins l'un des fil de grille ou fil de drain a une largeur inférieure à celle du bouchon de passage.

4. Dispositif semi-conducteur selon la revendication 1,
dans lequel la région source a une forme conique à chacune des deux extrémités.

5. Dispositif semi-conducteur selon la revendication 4, dans lequel la région source a une forme conique avec un angle d'environ 90 degrés aux deux extrémités.

6. Circuit électronique (1) comprenant :
au moins un dispositif semi-conducteur selon la revendication 1 ;
une ligne de signal d'entrée connectée au fil de grille de l'au moins un dispositif semi-conducteur pour transmettre le signal d'entrée ; et
une ligne de signal de sortie connectée au fil de drain de l'au moins un dispositif semi-conducteur pour transmettre le signal de sortie.

7. Circuit électronique selon la revendication 6, dans lequel
l'au moins un dispositif semi-conducteur comprend en outre :
une cinquième région de canal placée de manière adjacente à la première région de drain ; et
une quatrième électrode de grille placée sur une surface de la cinquième région de canal à travers un film isolant et connectée au fil de grille.

8. Circuit électronique selon la revendication 7, dans lequel
le dispositif semi-conducteur au moins comprend deux dispositifs semi-conducteurs,
le circuit électronique comprend en outre une région source commune adjacente aux deux cinquièmes régions de canal respectives des deux dispositifs semi-conducteurs,
la ligne de signal d'entrée est connectée aux deux fils de grille respectifs des deux dispositifs semi-conducteurs pour transmettre un signal d'entrée, et
la ligne de signal de sortie est connectée aux deux fils de drain respectifs des deux dispositifs semi-conducteurs pour transmettre un signal de sortie.

9. Circuit électronique selon la revendication 8,
comprenant en outre :
une électrode de source placée sur une surface de la région source commune ; et
un élément de circuit connecté entre l'électrode source et au moins l'une des lignes de signal d'entrée ou de signal de sortie.

10. Circuit électronique selon la revendication 9, dans lequel l'élément de circuit est un élément d'impédance.

11. Circuit électronique selon la revendication 10, dans lequel l'élément d'impédance est formé par une résistance, un inducteur ou un condensateur.

12. Circuit électronique selon la revendication 9, dans lequel l'élément de circuit est un embout court.
